Europäisches Patentamt

European Patent Office

Office européen des brevets

(19)

(11) Publication number: **0 162 460 B1**

(12) **EUROPEAN PATENT SPECIFICATION**

(45) Date of publication of patent specification: 28.08.91    (51) Int. Cl.5: **H01L 27/02, H01L 29/10**

(21) Application number: 85106300.8

(22) Date of filing: 22.05.85

(54) Integrated circuit with an input protective device.

<table>
<tr><td>(30) Priority: 22.05.84 JP 102865/84</td><td>(73) Proprietor: NEC CORPORATION<br>7-1, Shiba 5-chome Minato-ku<br>Tokyo 108-01(JP)</td></tr>
<tr><td>(43) Date of publication of application:<br>27.11.85 Bulletin 85/48</td><td></td></tr>
<tr><td></td><td>(72) Inventor: Sato, Yoshinori<br>c/o NEC Corporation 33-1, Shiba 5-chome<br>Minato-ku Tokyo(JP)</td></tr>
<tr><td>(45) Publication of the grant of the patent:<br>28.08.91 Bulletin 91/35</td><td></td></tr>
<tr><td>(84) Designated Contracting States:<br>DE FR GB</td><td>(74) Representative: Glawe, Delfs, Moll & Partner<br>Patentanwälte<br>Postfach 26 01 62 Liebherrstrasse 20<br>W-8000 München 26(DE)</td></tr>
<tr><td>(56) References cited:<br>EP-A- 0 106 417<br><br>PATENTS ABSTRACTS OF JAPAN, vol. 7, no.<br>251 (E-209)[1396], 8th November 1983; & JP -<br>A - 58 138 074<br><br>PATENTS ABSTRACTS OF JAPAN, vol. 5, no.<br>197 (E-86)[869], 15th December 1981; & JP - A<br>- 56 118 349<br><br>PATENTS ABSTRACTS OF JAPAN, vol. 5, no.<br>78 (E-58)[750], 22nd May 1981; & JP - A - 56<br>27 969<br><br>PATENTS ABSTRACTS OF JAPAN, vol. 3, no.<br>139 (E-152)[66], page 86 E 152; & JP - A - 54<br>116 887</td><td></td></tr>
</table>

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services

## Description

FIELD OF THE INVENTION:

The present invention relates to integrated circuits, and particularly input protective devices for integrated circuits.

In a semiconductor integrated circuit employing insulated gate field effect transistors (IGFET's), an input protective device is used for preventing any surge voltage from being applied to a gate of an input IGFET. A conventional input protective device is generally composed of an input protective resistor connected between the input terminal and the gate of an input IGFET to be protected and an input protective IGFET coupled between a portion of the input protective resistor and a referential potential with its drain-source path. The arrangement is such that any high surge voltage applied to the input terminal 1 is attenuated by the input protective resistor and is absorbed by a short-circuiting action of the input protective IGFET. The drain diffusion region of the input protective IGFET is connected to the protective resistor made of a polycrystalline silicon layer, while the source diffusion region and the gate electrode are connected to a referential voltage line made of aluminium. In this conventional input protective device, when a high surge voltage is applied to the input terminal and the protective IGFET allows to pass electric currents therethrough, the currents are concentrated to a defective portion of a thick field oxide surrounding the protective IGFET.

Positions of the defective portion of the field oxide are random but have the tendency to concentrade at the peripheral portions of the field oxide. The defective portions of the field oxide do not cause series problems by only themselves, but, if a large electric field is applied to the defective portions, a large current flows therethrough. The large electric current flowing through the limited portion of the channel causes a heat that raises the temperature, resulting in a termal breakdown of the protecting transistor.

A semiconductor device according to the preamble part of claim 1 is disclosed in JP-A-58-138074. In this device a resistor is connected between the gate of the protecting transistor and ground potential so that the potential difference between the drain and the gate of the transistor is reduced, and an electric field applied to gate oxide zone can be reduced to a small value. However, this device is not related to elimination of large currents which are concentrated to a defective portion of the field oxide.

From JP-A-56-118349 it is known to make the width of the gate of an FET wider at least on the drain side on the interface part of the device region and the thick field oxidized film than other parts. Thus, the possibility of a breakdown of the PN-junction can be reduced and electron emittance can also be prevented, resulting in a stabilization of the threshold voltage. However, this device is not related to protection of an input transistor.

It is therefore the object of the invention to avoid concentration of such currents to the defective parts of a thick field oxide film formed by the LOCOS method so that an input protective device capable of exhibiting a high protection effect against such voltage can be obtained.

This object is achieved by a semiconductor device comprising an input terminal, an input transistor, a resistive element coupled between the gate of said input transistor and said input terminal, a protecting transistor, first means for electrically connecting one of drain and source of said protection transistor to the gate of said input transistor, second means for electrically connecting the other of said drain and source of said protecting transistor to a reference voltage terminal, a resistor coupled between the gate of said protecting transistor and said reference voltage terminal, said input transistor and protecting transistor being formed on active regions surrounded by a field insulating layer, wherein the channel length around a central portion of said protecting transistor is made shorter than the other portions thereof and that a contact hole for allowing a connection to said one of drain and source of said protecting transistor is formed only at a central portion of said one of drain and source of said protecting transistor.

In a development of the invention an additional region having the opposite conductivity type to that of said drain and source of said protecting transistor is formed in said one of drain and source of said protecting transistor and said contract hole is formed on said additional region. According to the invention, an electric current flowing through the channel region is concentrated around the center portion of the channel region and the current density at the side portions or the peripheral portions of the channel region is reduced. Therefore, the current concentration near a field oxide layer, i.e. at the periphery of the channel region can be effectively avoided.

BRIEF DESCRIPTION OF THE DRAWINGS:

Fig. 1 is a circuit diagram of an example of a conventional input protective device;
Fig. 2 is a plan view showing the construction of the example shown in Fig. 1;
Fig. 3 is a circuit diagram of an protective device;
Fig. 4 is a plan view showing the construction of an embodiment of the invention;

Fig. 5 is a sectional diagram along the axis A-A' of Fig. 4; and

Fig. 6 is a sectional diagram showing another embodiment of the invention.

DETAILED DESCRIPTION OF THE INVENTION:

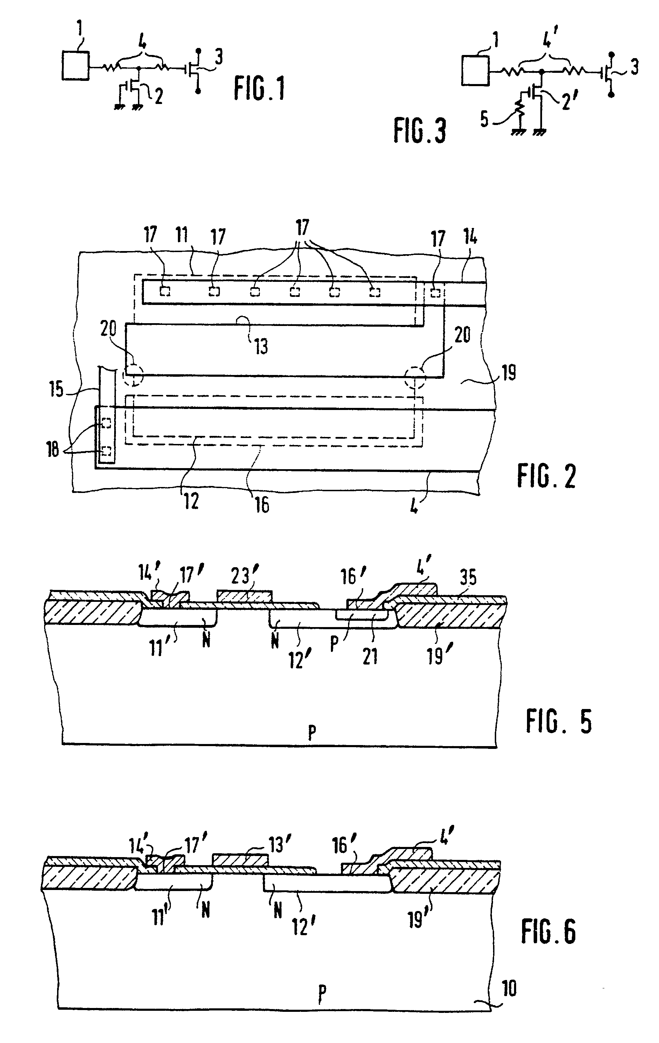

First, referring to Figs. 1 and 2, a protective device according to the prior art is described.

Fig. 1 is a circuit diagram of an example of a conventional input protective device, while Fig. 2 is a plan view showing the construction of the conventional input protective device shown in Fig. 1.

The input protective device has an input protective resistor 4 connected between the input terminal 1 and the input N-channel MIS transistor 3 (referred to as input transistor, hereinunder), and an input protective N-channel MIS transistor 2 (referred to as protective transistor, hereinunder) having the drain connected to a portion of the input protective resistor 4; the source and the gate which are connected to a ground voltage terminal. The arrangement is such that any high surge voltage applied to the input terminal 1 is attenuated by the input protective resistor and is absorbed by a short-circuiting action of the protective input transistor 2.

As will be seen from Fig. 2, in this conventional input protective device, the drain diffusion region 12 of the input protective transistor 2 is connected through an opening 16 to the protective resistor 4 constituted by a polycrystalline silicon layer, while the source diffusion region 11 and the gate electrode 13 are connected through an opening 17 to a ground voltage line 14 composed of aluminum. On the other hand, the protective resistor 4 is connected through an opening 18 to a line 15 composed of aluminum and leading to the input gate.

In this protective transistor, when a high surge voltage is applied as an input, electric currents are concentrated to a defective portion 20 (indicated by broken-line circle in Fig. 2) of a thick field oxide film 19 formed by LOCOS method such as to surround a part of the pattern, in particular the protective transistor. As a result, the protective transistor 2 is broken, thus failing to provide sufficient protection against surge voltage required by standard.

A preferred embodiment of the invention will be described hereinunder with reference to Figs. 3 to 5.

Fig. 3 shows a basic circuit diagram of a protective device.

This input protective device is basically composed of a protective resistor 4' connected between an input terminal 1 and the gate of an input transistor 3 to be protected, which is an N-channel MIS transistor, and a protective N-channel MIS transistor 2' having the drain connected to a portion of the protective resistor 4', the source connected to a ground terminal, and the gate connected to the ground terminal through a gate resistor 5.

According to this circuit arrangement, the gate of the protective transistor 2' is connected to the ground through the resistor 5, and therefore, when a surge voltage is applied to the input terminal 1, the potential at the gate of the protective transistor 2' is easily raised in response to the surge voltage through the gate-drain capacitance to make the transistor 2' conductive. Accordingly, the surge voltage is effectively discharged to the ground potential through the protective transistor 2'.

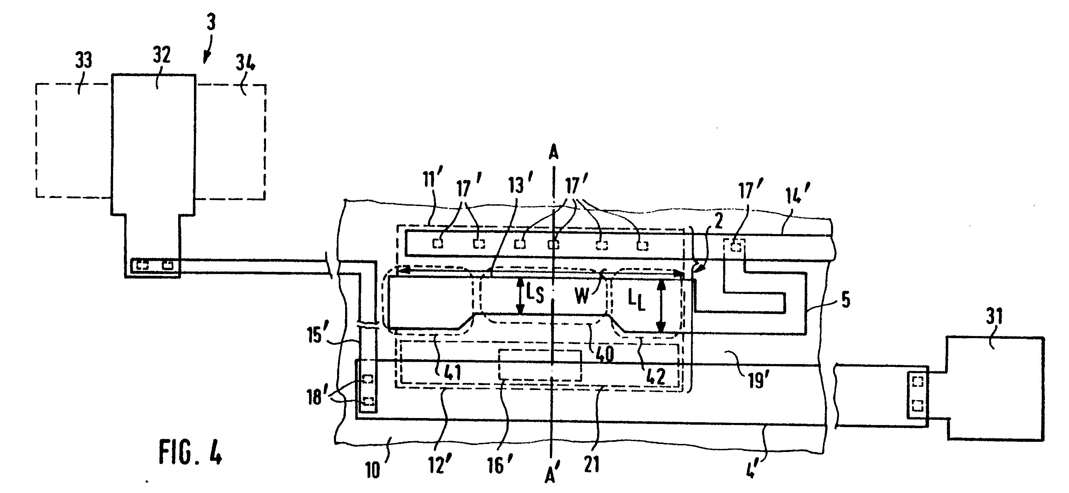

Referring to Figs. 3 and 4, a detailed embodiment of the invention is explained.

The N-channel input transistor 3 and the N-channel protective transistor 2' are formed on a P-channel semiconductor substrate 10.

The protective transistor 2' includes an N-type drain region 12', an N-type source 11' and a gate wiring 13' formed of a polycrystalline silicon. The input resistor 4' is coupled between the input pad 31 formed of aluminum and a gate wiring 15' connected to a gate electrode 32 of the input transistor 3 having a drain region 33 and a source region 34. At the periphery of the respective transistors, a thick field oxide layer 19' is formed in a well known manner. A P-type diffusion region 21 is formed in the drain region 12'. A surface insulating layer 35 is formed over the surface of the substrate 10. The protective resistor 4' is contacted to the drain region 12' through the P-type region 21 at an opening 16' formed in the insulating layer 35, as shown in Fig. 4. Differently from the device of Fig. 2, the opening 16' to the drain is located only at the central portion of the region 12', especially at 21. The ground voltage line 14' is formed of aluminum and connected to the resistive gate wiring 5 at a contact hole 17" and the source region 11' at a plurality of contact holes 17'. A channel length of the protective transistors 2' varies along the direction of a channel width W. Namely, the channel length Ls near the center portion 40 of the channel is made shorter than the channel length $L_L$ around the both side portions 41 and 42 of the channel. Accordingly, the effective conductance per unit width of the center portion 40 is made larger than those at the portions 41 and 42. Also, the distance between the portion 40 and the contact hole 16' is shorter than that between the portions 41 and 42 and the contact hole 16. Thus, current density at the portions 41 and 42 can be effectively reduced.

According to one typical example, values of the channel length Ls, $L_L$ and the channel width W are 11 $\mu$m, 14 $\mu$m and 80 $\mu$m, respectively. Also, the values of resistances of the resistors 4' and 5 are 1.2 K$\Omega$ and 500 $\Omega$, respectively.

According to the invention, a sufficiently high protection effect against a surge voltage is obtained for the following reasons:

(i) In the conventional device, the contact 16' to the polycrystalline silicon, through which the drain region 12 of the protective transistor 2 and the protective resistor 4 are connected to each other, is extended over the entire length of the drain region. In contrast, according to the invention, the opening 16' is reduced in size and formed at a location apart from the field oxide film 19', thereby preventing concentration of electric currents to the defective part of the field oxide film.

(ii) The gate electrode 13' of the protective transistor 2' is connected to the ground voltage line 14' through the gate resistor 5 consisting of polysilicon, thus facilitating the floating of the gate potential in the event of a surge voltage, whereby the protective transistor 2' is easily turned on thus allowing the surge voltage to be relieved to the grounding terminal.

(iii) The length (L) of the gate electrode 13' (i.e. channel region) composed of polycrystalline silicon of the protective transistor 2' is made shorter at the central portion adjacent the contact portion 16' so that the on-resistance of the protective transistor 2' is reduced to allow the concentration of the currents to the central portion of the protective transistor 2'.

In the above embodiment, the P-type region 21 is formed in the drain region 12' and the resistor 4' is connected to the drain region 12' through the P-type region 21.

However, it is also possible to directly connect the resistor 4' to the drain region 12' without forming the P-type region 21, as shown in Fig. 6.

The MIS integrated circuit device incorporating the described embodiment actually showed a high protection effective against a high surge voltage exceeding 250 V.

Although the foregoing description has been made by using an N-channel MIS transistor, this is not exclusive and the invention can be realized by a P-channel MIS transistor. In such a case, the drain and the source in the foregoing description are substituted by each other.

In addition, the number of the openings 16' may be increased as desired within the scope of the invention, although the described embodiment employs only one opening 16'.

As has been described, according to the invention, it is possible to avoid concentration of surge current to the defective part of the thick field oxide film formed by LOCOS method, so that an input protective device for MIS integrated circuit device, capable of exhibiting a high protection effect against surge voltage required by standard, can be obtained.

## Claims

1. A semiconductor device comprising an input terminal (31), an input transistor (3), a resistive element (4') coupled between the gate (32) of said input transistor and said input terminal, a protecting transistor (2), first means (15', 16') for electrically connecting one (12') of drain and source of said protecting transistor to the gate (32) of said input transistor, second means (14', 17') for electrically connecting the other (11') of said drain and source of said protecting transistor to a reference voltage terminal (GND), a restistor (5) coupled between the gate of said protecting transistor and said reference voltage terminal, said input transistor and protecting transistor being formed on active regions surrounded by a field insulating layer (19'), **characterized** in that the channel length (LS) around a center portion of said protecting transistor is made shorter than the other portions (LL) thereof and that a contact hole (16') for allowing a connection to said one (12') of drain and source of said protecting tansistor is formed only at a center portion of said one of drain and source of said protecting transistor.

2. A semiconductor device according to claim 1, **characterized** in that an additional regions having the opposite conductivity type of said drain and source of said protecting transistor is formed in said one of drain and source of said protecting transistor and said contact hole (16') is formed on said additional region.

## Revendications

1. Dispositif à semi-conducteur comprenant une borne d'entrée (31), un transistor d'entrée (3), un élément résistif (4') couplé entre la grille (32) du transistor d'entrée et la borne d'entrée, un transistor de protection (2), un premier moyen (15', 16') pour connecter électriquement un (12') parmi le drain et la source du transistor de protection à la grille (32) du transistor d'entrée, un second moyen (14', 17') pour connecter électriquement l'autre (11') parmi le drain et la source du transistor de protection à une borne de tension de référence (MAS), une résistance (5) couplée entre la grille du transistor de protection et la borne de tension de référence, le transistor d'entrée et le transistor de protection étant formés sur des régions actives entourées par une couche d'isolement de champ (19'), caractérisé en ce que la longueur du canal (LS) autour d'une partie centrale du transistor de protection est rendue plus courte que les autres parties (LL) de celui-ci et qu'un trou de contact (16') pour permettre une connexion a l'un parmi le drain et la source du transistor de protection est formé seulement à une partie centrale de l'un parmi le drain et la source du transistor de protection.

2. Dispositif à semi-conducteur selon la revendication 1, caractérisé en ce que des régions supplémentaires ayant le type de conductivité opposé du drain et de la source du transistor de protection est formé dans l'un parmi le drain et la source du transistor de protection et le trou de contact (16') est formé sur la région supplémentaire.

## Patentansprüche

1. Halbleiteranordnung mit einer Eingangsklemme (31), einem Eingangstransistor (3), einem Widerstandselement (4'), das zwischen dem Gate (32) des Eingangstransistors und der Eingangsklemme gekoppelt ist, einem Schutztransistor (2), einer ersten Einrichtung (15', 16') zum elektrischen Verbinden des Drain oder der Source (12') des Schutztransistors mit dem Gate (32) des Eingangstransistors, einer zweiten Einrichtung (14', 17') zum elektrischen Verbinden der jeweils anderen (11') von Drain oder Source des Schutztransistors mit einer Referenzspannungklemme (GND), einem Widerstand (5) der zwischen das Gate des Schutztransistors und die Referenzspannungsklemme gekoppelt ist, wobei Eingangstransistor und Schutztransistor auf aktiven Bereichen gebildet sind, die von einer Feldisolierenden Schicht (19') umgeben sind, dadurch **gekennzeinet,** daß die Kanallänge (LS) um einen mittleren Teil des Schutztransistors kürzer als dessen andere Teile (LL) ausgebildet ist, und daß nur in einem mittleren Teil der Drain oder der Source des Schutztransistors ein Kontaktloch (16') ausgebildet ist, um eine Verbindung mit der Drain oder Source (12') des Schutztransistors zu erlauben.

2. Halbleiteranordnung nach Anspruch 1 dadurch **gekennzeichnet,** daß ein zusätzlicher Bereich mit zum Leitertyp von Drain und Source des Schutztransistors entgegengesetztem Leitertyp in der Drain oder Source des Schutztransistors ausgebildet ist und das Kontaktloch (16') auf dem zusätzlichen Bereich ausgebildet ist.

FIG.1

FIG.3

FIG.2

FIG. 5

FIG.6

FIG. 4

EP 0 162 460 B1